# EUROPÄISCHE PATENTSCHRIFT

(11) **EP 1 929 551 B1**
(45) Veröffentlichungstag und Bekanntmachung des Hinweises auf die Patenterteilung: **27.06.2018**
(21) Anmeldenummer: 06818008.2
(22) Anmeldetag: 14.09.2006
(51) Int. Cl.: H01L 33/42, H01L 33/00

(54) **OPTOELEKTRONISCHER HALBLEITERCHIP**
OPTOELECTRONIC SEMICONDUCTOR CHIP
PUCE A SEMI-CONDUCTEUR OPTOELECTRONIQUE

(30) Priorität: 29.09.2005 DE 102005046691; 19.05.2006 DE 102006023685
(43) Veröffentlichungstag der Anmeldung: 11.06.2008
(73) Patentinhaber: OSRAM Opto Semiconductors GmbH, 93055 Regensburg (DE)
(72) Erfinder: PLÖSSL, Andreas, 93051 Regensburg (DE); WIRTH, Ralph, 93186 Pettendorf-Adlersberg (DE)
(74) Vertreter: Epping - Hermann - Fischer
(86) Internationale Anmeldenummer: PCT/DE2006/001616
(87) Internationale Veröffentlichungsnummer: WO 2007/036198

(56) Entgegenhaltungen:
- EP-A- 0 905 797
- WO-A-01/61765
- WO-A-01/82384
- DE-A1- 10 329 884
- US-A1- 5 837 561
- US-A1- 2003 116 770
- US-A1- 2004 104 390
- US-A1- 2004 188 791
- US-A1- 2005 196 887
- US-A1- 2005 205 875

## Beschreibung

Die Erfindung betrifft einen optoelektronischen Halbleiterchip.

In der Druckschrift EP 0 905 797 A2 werden strahlungsemittierende Halbleiterchips mit Halbleiterschichtenfolgen offenbart, die epitaktisch auf einem Wachstumssubstrat gewachsen sind. Da das Wachstumssubstrat in der Regel einen Teil der elektromagnetischen Strahlung absorbiert, die innerhalb der Halbleiterschichtenfolge erzeugt wird, wird in der Druckschrift EP 0 905 797 A2 vorgeschlagen, die epitaktische Halbleiterschichtenfolge mithilfe eines gesonderten Verbindungsmittels an einem gesonderten Trägerkörper zu befestigen und das Wachstumssubstrat zu entfernen. Als Material für den gesonderten Trägerkörper wird hierbei beispielsweise Metall aber auch semiisolierendes Silizium vorgeschlagen, das die Strahlung des Halbleiterchips absorbiert. Weiterhin wird als Verbindungsmittel beispielsweise ein Klebstoff oder ein Lot vorgeschlagen.

Ist der gesonderte Trägerkörper aus einem die Strahlungen des Halbleiterchips absorbierenden Material gefertigt, wie beispielsweise Metall oder Silizium, so kann aufgrund der Absorption der Strahlung die Effizienz des Halbleiterchips verringert werden.

In der Druckschrift WO 01/61765 A1 sind ein strahlungsemittierendes Halbleiterbauelement und ein Herstellungsverfahren hierfür angegeben, wobei ein strahlungsdurchlässiges Fenster an eine Halbleiterschichtenfolge angebracht wird.

Die Druckschrift US 2004/0188791 A1 betrifft eine LED und ein Herstellungsverfahren hierfür, wobei eine Halbleiterschichtenfolge an einem elektrisch leitenden Substrat befestigt wird.

Eine Aufgabe der vorliegenden Erfindung ist es, einen optoelektronischen Halbleiterchip mit guter Strahlungsausbeute anzugeben, der einfach hergestellt werden kann.

Diese Aufgabe wird durch einen optoelektronischen Halbleiterchip mit den Merkmalen des Anspruches 1 gelöst. Vorteilhafte Weiterbildungen und Ausführungsformen des Halbleiterchips sind in den Unteransprüchen 2 bis 7 angegeben.

Ein optoelektronischer Halbleiterchip, der elektromagnetische Strahlung von seiner Vorderseite emittiert, umfasst:
- eine Halbleiterschichtenfolge mit einem aktiven Bereich, der geeignet ist, die elektromagnetische Strahlung zu erzeugen, und
- ein an der Halbleiterschichtenfolge angeordnetes separat gefertigtes TCO-Stützsubstrat, das ein Material aus der Gruppe der transparenten leitenden Oxide (TCO) aufweist und die Halbleiterschichtenfolge mechanisch stützt.

Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO).

Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Ein optoelektronischer Halbleiterchip mit einem TCO-Stützsubstrat bietet den Vorteil, dass er zum Einen aufgrund der elektrischen Leitfähigkeit des TCOs über das TCO-Stützsubstrat elektrisch kontaktiert werden kann.

Weiterhin absorbiert das TCO-Stützsubstrat vorteilhafterweise keine oder einen vergleichsweise geringen Teil der Strahlung, die in der Halbleiterschichtenfolge im Betrieb erzeugt wird, da die TCOs durchlässig sind für die Strahlung des Halbleiterchips. Dies kann zu einer erhöhten Strahlungsausbeute des Halbleiterchips gegenüber einem Halbleiterchip mit einem absorbierenden Substrat, wie beispielsweise einem epitaktischen Wachstumssubstrat oder aber auch einem gesonderten strahlungsundurchlässigen Träger, beitragen.

Der aktive strahlungserzeugende Bereich des Halbleiterchips umfasst bevorzugt einen pn-Übergang, eine Doppelheterostruktur, einen Einfachquantentopf oder besonders bevorzugt eine Mehrfachquantentopfstruktur zur Strahlungserzeugung. Die Bezeichnung "Quantentopfstruktur" beinhaltet hierbei keine Angabe über die Dimensionalität der Quantentopfstruktur. Sie umfasst somit unter anderem Quantentröge, Quantendrähte und Quantenpunkte und jede Kombination dieser Strukturen. Beispiele für MQW-Strukturen sind in den Druckschriften WO 01/39282, US 5,831,277, US 6,172,382 B1 und US 5,684,309 beschrieben.

Die Halbleiterschichtenfolge basiert beispielsweise auf einem III/V-Verbindungshalbeitermaterial, wie einem Nitrid-Verbindungshalbleitermaterial, einem Phosphid-Verbindungshalbleitermaterial oder einem Arsenid-Verbindungshalbleitermaterial.

Vorliegend bedeutet "basiert auf Nitrid-Verbindungshalbleitermaterial", dass zumindest ein Teil der Halbleiterschichtenfolge ein Nitrid/III-Verbindungshalbleitermaterial umfasst, vorzugsweise AlₙGaₘIn₁₋ₙ₋ₘN, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘInₗ₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Äquivalent bedeutet vorliegend "basiert auf Phosphid-Verbindungshalbleitermaterial", dass zumindest ein Teil der Halbleiterschichtenfolge ein Phosphid/III-Verbindungshalbleitermaterial umfasst, vorzugsweise AlₙGaₘInₗ₋ₙ₋ₘP, wobei 0 ≤ n ≤ 1, 0 ≤ m ≤ 1 und n+m ≤ 1. Dabei muss auch dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘInₗ₋ₙ₋ₘP-Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Ebenfalls äquivalent zu "basiert auf Nitrid-Verbindungshalbleitermaterial" und "basiert auf Phosphid-Verbindungshalbleitermaterial" bedeutet vorliegend "basiert auf Arsenid-Verbindungshalbleitermaterial", dass zumindest ein Teil der Halbleiterschichtenfolge ein Arsenid/III-Verbindungshalbleitermaterial umfasst, vorzugsweise AlₙGaₘInₗ₋ₙ₋ₘAs, wobei 0 ≤ n ≤ 1, 0 ≤ m ≤ 1 und n+m ≤ 1. Auch dieses Material muss nicht zwingend eine mathematisch exakte Zusammensetzung nach obiger Formel aufweisen und kann ein oder mehrere Dotierstoffe sowie zusätzliche Bestandteile aufweisen, die die charakteristischen physikalischen Eigenschaften des AlₙGaₘInₗ₋ₙ₋ₘAs-Materials im Wesentlichen nicht ändern. Wiederum beinhaltet obige Formel der Einfachheit halber jedoch nur die wesentlichen Bestandteile des Kristallgitters (Al, Ga, In, As), auch wenn diese teilweise durch geringe Mengen weiterer Stoffe ersetzt sein können.

Bei einer bevorzugten Ausführungsform weist das TCO-Stützsubstrat einen Brechungsindex auf, der kleiner ist als der Brechungsindex der Halbleiterschichtenfolge. In der Regel weisen die TCOs sogar einen deutlich kleineren Brechungsindex auf als die Halbleiterschichtenfolge. Besonders bevorzugt weist der Brechungsindex des TCO-Substrates einen Wert kleiner oder gleich 2 und der Brechungsindex der Halbleiterschichtenfolge einen Wert größer gleich 3 auf. Die Halbleiterschichtenfolge kann aber auch einen Brechungsindex aufweisen, der zwischen 2,2 und 3 liegt, wobei die Grenzen eingeschlossen sind, beispielsweise wenn die Halbleiterschichtenfolge auf einem Nitrid-Verbindungshalbleitermaterial basiert.

Weist das TCO-Stützsubstrat einen Brechungsindex auf, der deutlich kleiner ist als der der Halbleiterschichtenfolge, so bringt dies den Vorteil mit sich, dass ein wesentlicher Teil der elektromagnetischen Strahlung des aktiven Bereiches, der auf die Grenzfläche TCO-Stützsubstrat/Halbleiterschichtenfolge trifft, dort bereits in die Halbleiterschichtenfolge zurückreflektiert wird und nicht in das TCO-Stützsubstrat eindringt.

Bei einer weiteren Ausführungsform ist das TCO-Stützsubstrat mittels direktem Bonden ("direct bonding"), Diffusionsbonden ("diffusion bonding") oder Kleben an der Halbleiterschichtenfolge angebracht.

Direktes Bonden und Diffusionsbonden sind im Gegensatz zum Kleben Verbindungsmethoden, die ohne Fügeschicht auskommen. Mit Hilfe von direktem Bonden werden Fügepartner miteinander verbunden, indem diese miteinander in Kontakt gebracht werden, so dass die Fügepartner auf Grund von schwachen Wechselwirkungen, wie Van-der-Waals Kräften oder durch Ausbildung von Wasserstoffbrückenbindungen, aneinander haften. Durch Beaufschlagung der Fügepartner mit Temperatur kann deren Adhäsion aneinander vorteilhafterweise erhöht werden.

Diffusionsbonden und direktes Bonden unterscheiden sich insbesondere durch die Anforderungen an die Rauhigkeit der zu verbindenden Oberflächen.

Für das direkte Bonden müssen die Fügepartner hinreichend ebene und glatte Oberflächen bevorzugt mit einem rms-Wert kleiner oder gleich 1 nm aufweisen, so dass die Wechselwirkungsenergie zwischen den zu verbindenden Oberflächen beim Kontakt ausreicht, die Fügepartner elastisch zu verbiegen und einen ganzflächig ausgebildeten mechanischen Kontakt zwischen ihnen zu erzielen. Je nach Reaktivität der Oberfläche reicht dieser atomare Kontakt aus, starke chemische Bindungen (kovalent, ionisch, metallisch) auszubilden oder nicht. Sind die entstandenen chemischen Bindungen zwischen den Fügepartnern zu schwach ausgebildet, so kann eine Beaufschlagung mit Temperatur die Bindung verbessern.

Beim Diffusionsbonden sind die Anforderungen an die Oberflächenrauhigkeit geringer - es können hier in der Regel Oberflächen mit einem rms-Wert bis zu max. 0,4 µm verbunden werden - jedoch ist hier Beaufschlagung mit Druck und Temperatur notwendig, um eine ausreichende Bindung zwischen den Fügepartnern zu erzielen. Die Temperaturbeaufschlagung erfolgt hierbei bevorzugt mit homologen Temperaturen (Temperatur in K bezogen auf den Schmelzpunkt des jeweiligen Materials) zwischen 0,5 bis 0,8, wobei die Grenzen eingeschlossen sind. Die Druckbeaufschlagung erfolgt bevorzugt mit einem Druck im Bereich der Fließspannung des Materials der zu verbindenden Fügepartner.

Insbesondere Verbindungsmethoden ohne Fügeschicht, wie beispielsweise direktes Bonden oder Diffusionsbonden, bieten den Vorteil, dass das Fügemittel der Fügeschicht, wie beispielsweise ein Klebstoff, nicht ausgasen und den Halbleiterchip verunreinigen kann. Dies ermöglicht es in der Regel, bei der Fertigung des Halbleiterchips nach dem Verbindungsschritt Prozesse mit höheren Temperaturen anzuwenden, als in dem Fall, dass die Verbindung zwischen TCO-Stützsubstrat und Halbleiterschichtenfolge mit Hilfe einer Fügeschicht hergestellt wurde. Weiterhin ist die Temperaturbeständigkeit und Chemikalienbeständigkeit des Halbleiterchips nicht durch das Fügemittel beschränkt. Hierdurch erschließen sich unter Umständen breitere Anwendungsfelder für den Halbleiterchip und es wird eine breitere Auswahl an weiteren Prozessschritte anschließend an die Herstellung des Halbleiterchips ermöglicht, beispielsweise aus der Aufbau- und Verbindungstechnik, wie die Lötmontage auf eine Platine mit geringem thermischen Widerstand.

Gegenüber den Verbindungsmethoden ohne Fügeschicht bieten Verbindungsmethoden mit Fügeschicht, wie beispielsweise Kleben, den Vorteil, in der Regel einfacher und günstiger durchgeführt werden zu können. Weiterhin können mit einer Fügeschicht vorteilhafterweise Unebenheiten der zu verbindenden Oberflächen ausgeglichen werden. Da die Halbleiterschichtenfolge bei den Verbindungsmethoden ohne Fügeschicht in der Regel mit Druck und/oder Temperatur beaufschlagt werden müssen, ist die Gefahr größer, dass die Halbleiterschichtenfolge und insbesondere deren aktiver Bereich hierbei beschädigt werden.

Ist das TCO-Stützsubstrat mittels Kleben an der Halbleiterschichtenfolge angebracht, so kann beispielsweise ein elektrisch leitender Klebstoff verwendet werden, um den Halbleiterchip über das TCO-Stützsubstrat einfach elektrisch leitend verbinden zu können, beispielsweise mit Leiterbahnen einer Platine oder elektrischen Kontaktbereichen eines Gehäuses.

Um mittels eines elektrisch isolierenden Klebstoffes, wie beispielsweise BCB, eine elektrisch leitende Verbindung zwischen den Fügepartnern zu erzeugen, wird die Klebstoffschicht so dünn gewählt, dass die zu verbindenden Oberflächen über Erhebungen auf Grund ihrer Rauhigkeit zumindest teilweise miteinander in direktem Kontakt stehen und so ein elektrischer Kontakt zwischen ihnen ausgebildet wird. Um den elektrischen Kontakt zwischen TCO-Stützsubstrat und Halbleiterschichtenfolge bei dieser Ausführungsform zu verbessern, können weiterhin lokale metallische Kontaktstellen auf den jeweils zu verbindenden Oberflächen angeordnet sein, bevorzugt derart, dass diese beim Fügeschritt aufeinander zu liegen kommen. Es können mit dieser Methode in der Regel Oberflächen miteinander verbunden werden, die eine Mindestrauhigkeit von einigen nm aufweisen.

Bei einer weiteren bevorzugten Ausführungsform ist zwischen der Halbleiterschichtenfolge und dem TCO-Stützsubstrat eine TCO-Schicht angeordnet, die ein Material aus der Gruppe der TCOs aufweist. Diese TCO-Schicht kann zum Einen verwendet werden, um insbesondere bei den fügeschichtlosen Verbindungsmethoden Rauhigkeiten der zu verbindenden Oberfläche zu verringern. Hierzu wird die TCO-Schicht beispielsweise auf die Halbleiterschichtenfolge aufgebracht und die zu verbindenden Oberfläche der TCO-Schicht chemomechanisch poliert. Hierbei muss der Materialverlust beim Polieren bei der Bemessung der Dicke der TCO-Schicht berücksichtigt werden. Die Dicke der TCO-Schicht liegt bevorzugt zwischen 50 nm und 10 µm, wobei die Grenzen eingeschlossen sind. Besonders bevorzugt liegt die Dicke der TCO-Schicht zwischen 50 nm und 2 µm, wobei wiederum die Grenzen eingeschlossen sind.

Weiterhin kann die TCO-Schicht auch als Kontaktschicht dienen, die den elektrischen Kontakt zwischen der Halbleiterschichtenfolge und dem TCO-Stützsubstrat verbessert, vorzugsweise dahingehend, dass dieser eine im Wesentlichen Ohmsche Charakteristik aufweist. Die TCO-Schicht kann beispielsweise mittels eines Epitaxieprozesses, durch Sputtern, Bedampfen oder einen Sol-Gel-Prozess aufgebracht sein.

Weiterhin ist erfindungsgemäß zwischen der Halbleiterschichtenfolge und dem TCO-Stützsubstrat, auch zusätzlich zu der TCO-Schicht, eine TCO-Kontaktschicht angeordnet. Die TCO-Kontaktschicht weist ebenfalls ein Material aus der Gruppe der TCOs auf und dient dazu, den elektrischen Kontakt zwischen Halbleiterschichtenfolge und TCO-Stützsubstrat zu verbessern, bevorzugt derart, dass dieser eine im Wesentliche Ohmsche Charakteristik aufweist. Die TCO-Kontaktschicht kann ebenfalls beispielsweise mittels eines Epitaxieprozesses, durch Sputtern, Bedampfen oder einem Sol-Gel-Prozess aufgebracht sein.

Die TCO-Kontaktschicht sowie die TCO-Schicht können auch mit einem Dotiertstoff versehen sein, bevorzugt handelt es sich hierbei um einen n-Dotierstoff, wie Al, B, Ga, In, Si, Ge, Ti, Zr oder Hf. n-Dotierstoffe sind beispielsweise in der Druckschrift mit dem Titel "New n-type tranparent conducting oxides", T. Minami, MRS Bulletin, August 2000, beschrieben.

Weiterhin kann die TCO-Kontaktschicht auch mehrere Schichten umfassen. So ist es beispielsweise möglich, dass die TCO-Kontaktschicht eine n-dotierte Schicht umfasst, die bevorzugt direkt an das TCO-Stützsubstrat angrenzt, und eine ebenfalls n-dotierte Querleitschicht, die bevorzugt direkt an die Halbleiterschichtenfolge angrenzt, wobei die n-dotierte Schicht eine höhere Dotierung aufweist als die Querleitschicht.

Erfindungsgemäß weist die TCO-Kontaktschicht eine Dicke auf, die zwischen 1 µm und 5 µm liegt, wobei die Grenzen jeweils eingeschlossen sind.

Mittels der TCO-Schicht oder der TCO-Kontaktschicht oder beiden Schichten, kann der elektrische Kontakt zwischen TCO-Stützsubstrat und Halbleiterschichtenfolge in der Regel verbessert werden, da diese Schichten auf die Halbleiterschichtenfolge mit einem geeigneten Abscheideverfahren aufgebracht werden können, wie beispielsweise Sputtern, bei dem ein guter leitender Kontakt zwischen der abgeschiedenen Schicht und dem Halbleitermaterial erzielt wird. Einen guten elektrischen Kontakt zwischen TCO-Stützsubstrat und TCO-Schicht bzw. TCO-Kontaktschicht beim Fügeschritt zu erreichen, ist in der Regel deutlich einfacher, als beim Fügen von Halbleiterschichtenfolge und TCO-Stützsubstrat.

Bei einer weiteren besonders bevorzugten Ausführungsform ist zwischen dem aktiven Bereich der Halbleiterschichtenfolge und der Rückseite des Halbleiterchips, die dessen Vorderseite gegenüberliegt, und besonders bevorzugt zwischen Halbleiterschichtenfolge und TCO-Stützsubstrat, eine reflektierende Schicht angeordnet, die die Strahlung des Halbleiterchips reflektiert. Mithilfe einer solchen reflektierenden Schicht kann die Reflexion von elektromagnetischer Strahlung, die von der Halbleiterschichtenfolge in Richtung TCO-Stützsubstrat ausgesandt wird, zurück in die Halbleiterschichtenfolge verbessert werden. Dies erhöht die Strahlungsausbeute des Halbleiterchips.

Die reflektierende Schicht kann hierbei auch aus mehreren Schichten aufgebaut oder beispielsweise auch nur teilflächig beziehungsweise lateral strukturiert ausgebildet sein.

Besonders bevorzugt wird als reflektierende Schicht ein Distributed-Bragg-Reflektorspiegel (kurz "DBR-Spiegel") eingesetzt. Ein DBR-Spiegel umfasst eine Folge von Schichten, deren Brechungsindizes alternierend hoch und niedrig sind. Ein DBR-Spiegel reflektiert insbesondere Strahlung, die senkrecht zu seiner Oberseite einfällt. Weist das TCO-Stützsubstrat einen kleineren Brechungsindex auf als die angrenzende Halbleiterschichtenfolge, wird insbesondere schräg zur Grenzfläche Halbleitermaterial/Stützsubstrat einfallende Strahlung an dieser Grenzfläche reflektiert, während senkrecht zu dieser Grenzfläche einfallende Strahlung verloren geht. Daher ist ein DBR-Spiegel zwischen dem aktiven Bereich der Halbleiterschichtenfolge und dem Stützsubstrat besonders geeignet, die Strahlungsausbeute des Halbleiterchips zu erhöhen.

Zusätzlich oder alternativ zu der reflektierenden Schicht zwischen dem aktiven Bereich der Halbleiterschichtenfolge und dem TCO-Stützsubstrat umfasst die Rückseite des Halbleiterchips bevorzugt eine Metallschicht. Diese lenkt zum Einen, wie die oben beschriebene reflektierende Schicht zwischen aktivem Bereich der Halbleiterschichtenfolge und Stützsubstrat, Strahlung zur Vorderseite des Halbleiterchips und erhöht damit dessen Strahlungsausbeute. Zum Anderen verbessert die Metallschicht in der Regel den elektrischen Kontakt der Rückseite des Halbleiterchips zu einem Leitkleber oder einer Lotschicht, die häufig verwendet werden, um den Halbleiterchip später in einem Gehäuse oder auf einer Platine zu montieren.

Weiterhin ist die Vorderseite des Halbleiterchips bevorzugt aufgeraut. Die Aufrauung der Vorderseite des Halbleiterchips verringert die Mehrfachreflexionen von Strahlung an den Oberflächen des Halbleiterchips und trägt daher zur verbesserten Strahlungsauskopplung bei. Es sind auch andere Strukturen an der Vorderseite des Halbleiterchips zur effizienteren Strahlungsauskopplung denkbar, beispielsweise periodische Strukturen, deren laterale Abmessungen kleiner oder gleich der Wellenlänge der vom Halbleiterchip emittierten Strahlung sind.

Bevorzugt umfasst der Halbleiterchip weiterhin eine Stromaufweitungsschicht, die auf der zur Vorderseite des Halbleiterchips gewandten Seite der Halbleiterschichtenfolge aufgebracht ist und ein Material aus der Gruppe der TCOs umfasst. Die Stromaufweitungsschicht führt vorteilhafterweise dazu, dass Strom, der vorderseitig in den Halbleiterchip eingeprägt wird, lateral möglichst gleichmäßig in die Halbleiterschichtenfolge und insbesondere in deren aktiven strahlungserzeugenden Bereich verteilt wird. Dies führt zu einer Erhöhung der Strahlungserzeugung bei gleichbleibender Bestromung und auch zu einer homogeneren Abstrahlcharakteristik des Halbleiterchips. Weiterhin kann eine Stromaufweitungsschicht aus TCO vorteilhafterweise deutlich dünner ausgebildet sein als eine Stromaufweitungsschicht aus Halbleitermaterial. Außerdem absorbiert eine Stromaufweitungsschicht aus TCO im Vergleich mit einer Stromaufweitungsschicht aus einem Material mit einem höheren Absorptionskoeffizienten für die Strahlung des Halbleiterchips, wie beispielsweise einem Metall, deutlich weniger Strahlung.

Zur vorderseitigen elektrischen Kontaktierung des Halbleiterchips umfasst dessen Vorderseite bei einer bevorzugten Ausführungsform einen elektrisch leitenden Bondpad. Über diesen elektrisch leitenden Bondpad kann der Halbleiterchip, beispielsweise mittels eines Bonddrahts, mit einem elektrischen Anschluss eines Gehäuses oder einer elektrischen Anschlussbahn einer Platine elektrisch leitend verbunden sein.

Im Folgenden wird die Erfindung anhand von vier Ausführungsbeispielen in Verbindung mit den Figuren 1 bis 4 näher erläutert.

Es zeigen:
Figur 1, schematische Schnittdarstellung eines Halbleiterchips gemäß einem ersten Ausführungsbeispiel,
Figur 2, schematische Schnittdarstellung eines Halbleiterchips gemäß einer Abwandlung,
Figur 3, schematische Schnittdarstellung eines Halbleiterchips gemäß einem zweiten Ausführungsbeispiel, und
Figur 4, schematische Schnittdarstellung eines Halbleiterchips gemäß einem dritten Ausführungsbeispiel.

In den Ausführungsbeispielen und Figuren sind gleiche oder gleich wirkende Bestandteile jeweils mit den gleichen Bezugszeichen versehen. Die dargestellten Elemente sind grundsätzlich nicht als maßstabsgerecht anzusehen, vielmehr können einzelne Elemente, wie z. B. Schichtdicken, zum besseren Verständnis übertrieben groß dargestellt sein.

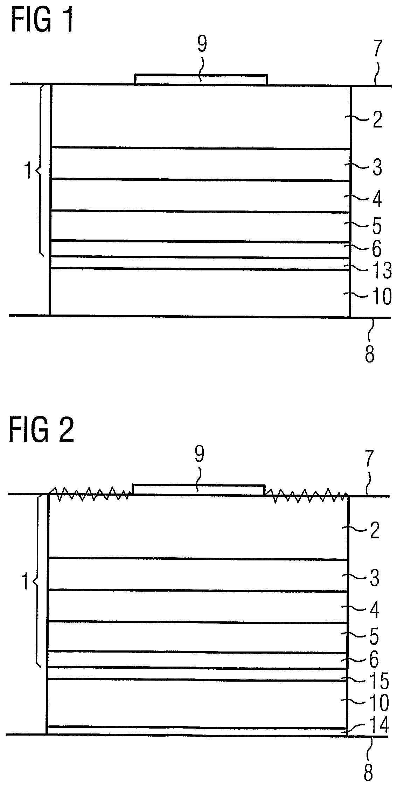

Bei dem Ausführungsbeispiel gemäß Figur 1 umfasst der Halbleiterchip eine Halbleiterschichtenfolge 1 mit einer n-seitig aufgebrachten Stromaufweitungsschicht 2, einer n-Mantelschicht 3, einem aktiven Bereich 4, einer p-Mantelschicht 5 und einer p-Kontaktschicht 6. Der aktive Bereich 4 ist zwischen der p-Mantelschicht 5 und der n-Mantelschicht 3 angeordnet, wobei die n-Mantelschicht 3 zwischen dem aktiven Bereich 4 und der strahlungsemittierenden Vorderseite 7 des Halbleiterchips und die p-Mantelschicht 5 zwischen dem aktiven Bereich 4 und der Rückseite 8 des Halbleiterchips angeordnet sind. Die p-Kontaktschicht 6 ist auf die Seite der p-Mantelschicht 5 aufgebracht, die der Rückseite 8 des Halbleiterchips zugewandt ist, während die Stromaufweitungsschicht 2 der n-Mantelschicht 3 in Abstrahlrichtung des Halbleiterchips nachgeordnet ist. Auf die Stromaufweitungsschicht 2 ist weiterhin ein vorderseitiger elektrischer Bondpad 9 aufgebracht, von dem sich beispielsweise Kontaktfinger lateral über die Vorderseite 7 des Halbleiterchips erstrecken (in der Figur nicht dargestellt) und auf den ein Bondraht zur elektrischen Kontaktierung des Halbleiterchips mit einem elektrisch leitenden Bereich eines Gehäuses oder einer Platine aufgebracht werden kann. Alternativ kann der Halbleiterchip auch dazu vorgesehen sein, vorderseitig unter Verzicht auf einen Bonddraht elektrisch kontaktiert zu werden, beispielsweise mittels einer elektrisch leitenden Schicht, die die Vorderseite 7 des Halbleiterchips mit einem elektrisch leitenden Bereich eines Gehäuses oder einer Platine elektrisch leitend verbindet.

Auf die zur Rückseite 8 des Halbleiterchips weisende Seite der p-Kontaktschicht 6 ist weiterhin eine TCO-Kontaktschicht 13 aufgebracht, die mit einem TCO-Stützsubstrat 10 fügeschichtslos, beispielsweise mittels Diffusionsbonden oder direktem Bonden, verbunden ist. Das TCO-Stützsubstrat 10 weist ein Material aus der Gruppe der TCOs auf und ist daher elektrisch leitend und durchlässig für die Strahlung des Halbleiterchips. Weiterhin muss das Material der TCO-Kontaktschicht nicht zwingend mit dem Material des TCO-Stützsubstrates übereinstimmen.

Die Halbleiterschichtenfolge 1 basiert vorliegend auf einem Phosphid-Verbindungshalbleitermaterial. Der aktive Bereich 4 umfasst vorliegend beispielsweise undotiertes InGaAlP, weist eine Dicke zwischen 100 nm und 1 µm auf und erzeugt im Betrieb elektromagnetische Strahlung aus dem gelben bis roten Spektralbereich des sichtbaren Lichtes. Die n-Mantelschicht 3 umfasst n-dotiertes und die p-Mantelschicht 5 p-dotiertes InAlP. Die Mantelschichten 3, 5 weisen jeweils eine Dicke zwischen 200 nm und 1 µm auf. Die p-Kontaktschicht 6 umfasst hoch p-dotiertes AlGaAs und ist zwischen 50 nm und 200 nm dick. Die Stromaufweitungsschicht 2 umfasst InGaAlP oder AlGaAs und hat vorzugsweise eine Dicke zwischen 1 µm und 10 µm. Die TCO-Kontaktschicht 13 umfasst ein TCO, vorliegend beispielsweise mit 2% Aluminium dotiertes Zinkoxid und weist eine Dicke zwischen 50 nm und 2000 nm auf.

Wie bereits im allgemeinen Teil der Beschreibung erwähnt, umfasst der aktive Bereich 4 zur Strahlungserzeugung beispielsweise einen pn-Übergang, eine Doppelheterostruktur, einen Einfachquantentopf oder eine Mehrfachquantentopfstruktur. Die n-Mantelschicht 3 und die p-Mantelschicht 5 haben die Aufgabe, die jeweiligen Ladungsträger auf den aktiven Bereich 4 einzugrenzen. Die p-Kontaktschicht 6 dient weiterhin dazu, einen verbesserten elektrischen Kontakt, bevorzugt mit Ohmscher Charakteristik, zwischen TCO-Kontaktschicht 13 und Halbleiterschichtenfolge 1 herzustellen, während mit Hilfe der Stromaufweitungsschicht 2 Strom, der über den vorderseitigen Bondpad 9 in den Halbleiterchip eingeprägt wird, lateral möglichst gleichmäßig in die Halbleiterschichtenfolge 1 und insbesondere in den aktiven strahlungserzeugenden Bereich 4 verteilt wird.

Die Halbleiterschichtenfolge 1 wird vorliegend epitaktisch beispielsweise auf einem GaAs-Wachstumssubstrat gewachsen. Nachfolgend wird auf die zur Rückseite 8 des Halbleiterchips gewandte Seite der p-Kontaktschicht 6 die TCO-Kontaktschicht 13 angebracht. Diese kann beispielsweise epitaktisch, mittels Sputtern, Bedampfen oder mit Hilfe eines Sol-Gel-Prozesse aufgebracht werden. Sol-Gel-Prozesse zur Aufbringung von TCO-Schichten sind beispielsweise in den Druckschriften DE 197 19 162 A1 und L. Spanhel et al., "Semiconductor Clusters in Sol-Gel Process: Quantized Aggregation, Gelation and Crystal Growth in Concentrated ZnO Colloids, J. Am. Chem. Soc. (1991), 113, 2826-2833 beschrieben.

Auf die TCO-Kontaktschicht 13 wird anschließend ein TCO-Stützsubstrat 10 beispielsweise aus ZnO oder ITO mit einer Dicke zwischen 50 µm und 200 µm mittels Diffusionsbonden aufgebracht. Hierzu werden die Grenzflächen des TCO-Stützsubstrats 10 und des TCO-Kontaktschicht 13 miteinander in Kontakt gebracht und mit Temperaturen zwischen 1075°C und 1525°C sowie Druck im Bereich der Fließspannung der zu verbindenden Fügepartner über einige Stunden beaufschlagt, so dass eine stoffschlüssige, mechanisch stabile Verbindung zwischen der TCO-Kontaktschicht 13 und dem TCO-Stützsubstrat 10 entsteht. In der Regel bildet sich weiterhin mit Vorteil eine elektrisch leitende Verbindung zwischen TCO-Kontaktschicht 13 und dem TCO-Stützsubstrat 10 aus.

Nach dem Aufbringen des TCO-Stützsubstrates 10 wird das Wachstumssubstrat gedünnt oder entfernt, beispielsweise durch Schleifen und/oder selektives nasschemisches Ätzen.

Auf Grund des Unterschiedes zwischen dem Brechungsindex der Halbleiterschichtenfolge 1 (n(InGaAlP) ≈3.5) und dem Brechungsindex des TCO-Stützsubstrats 10 (n(ZnO)≈1.85) wird bei dem Halbleiterchip der Figur 1 Strahlung, die im aktiven Bereich 4 der Halbleiterschichtenfolge 1 erzeugt wird und auf die Grenzfläche Halbleiterschichtenfolge 1/TCO-Stützsubstrat 10 trifft, in die Halbleiterschichtenfolge 1 zurück reflektiert.

Im Unterschied zum Halbleiterchip gemäß dem Ausführungsbeispiel der Figur 1, umfasst der Halbleiterchip bei der Abwandlung gemäß der Figur 2 eine aufgeraute Vorderseite 7, die beispielsweise durch Ätzen erzeugt werden kann. Die Aufrauung der Vorderseite des Halbleiterchips 7 ermöglicht eine bessere Auskoppelung der Strahlung aus dem Halbleiterchip in die Umgebung, da Strahlungsverluste aufgrund von Mehrfach-Reflexion an den Grenzflächen Halbleiterkörper/Umgebung in der Regel vermindert werden.

Weiterhin umfasst die Rückseite 8 des Halbleiterchips der Abwandlung gemäß Figur 2 eine Metallschicht 14, die vorgesehen ist, den elektrischen Kontakt zu einem Leitkleber oder Lot zu verbessern, mittels dem der Halbleiterchip zu einem späteren Zeitpunkt in einem Gehäuse oder auf einer Platine montiert wird. Weiterhin reflektiert die Metallschicht 14 Strahlung, die innerhalb der Halbleiterschichtenfolge 1 erzeugt wird, in diese zurück. Die Metallschicht 14 weist beispielsweise Gold oder Aluminium auf.

Im Unterschied zum Halbleiterchip gemäß der Figur 1 weist der Halbleiterchip gemäß der Abwandlung in Figur 2 keine TCO-Kontaktschicht 13 auf, sondern eine TCO-Schicht 15, die vorliegend im Wesentlichen das selbe TCO-Material aufweist, wie das TCO-Stützsubstrat 10, nämlich ZnO. Bei dem vorliegenden Beispiel ist das TCO-Stützsubstrat 10 mit der TCO-Schicht 15 mittels direktem Bonden verbunden. Hierzu müssen die zu verbindenden Oberflächen der Fügepartner in der Regel Rauhigkeiten aufweisen, die kleiner oder gleich einem Nanometer sind. Ist dies nicht der Fall, werden die zu verbindenden Oberflächen der Fügepartner entsprechend poliert. Muss die TCO-Schicht 15 poliert werden, so muss dies bei der Wahl ihrer Dicke entsprechend berücksichtigt werden.

Liegen die Rauhigkeiten der Oberflächen der Fügepartner TCO-Stützsubstrat 10 und TCO-Schicht 15 unter dem oben angegeben Wert, werden diese in direkten Kontakt miteinander gebracht und mit Temperaturen zwischen 300°C und 1000°C über einige Stunden beaufschlagt, so dass eine stoffschlüssige, mechanisch stabile Verbindung zwischen TCO-Stützsubstrat 10 und TCO-Schicht 15 entsteht. Hierbei bildet sich in der Regel mit Vorteil eine elektrisch leitende Verbindung zwischen TCO-Kontaktschicht 13 und dem TCO-Stützsubstrat 10 aus. Weiterhin kann zusätzlich zu der Beaufschlagung mit Temperatur auch eine Beaufschlagung mit Druck bis ca. 20 bar erfolgen. Dies ist jedoch in der Regel nicht zwingend erforderlich.

Es sei an dieser Stelle darauf hingewiesen das die TCO-Schicht 15 nicht nur alternativ zu der TCO-Kontaktschicht 13 verwendet werden kann, sondern auch zusätzlich. In diesem Fall ist die TCO-Kontaktschicht 13 entweder zwischen der p-Kontaktschicht 6 und der TCO-Schicht 15 oder zwischen der TCO-Schicht 15 und dem TCO-Stützsubstrat 10 angeordnet.

Weiterhin können die zu verbindenden Oberflächen stark n-dotiert werden, beispielsweise mit einem der im allgemeinen Beschreibungsteil bereits genannten n-Dotierstoffe, um den elektrischen Kontakt zwischen dem TCO-Stützsubstrat 10 und der Halbleiterschichtenfolge 1 zu verbessern.

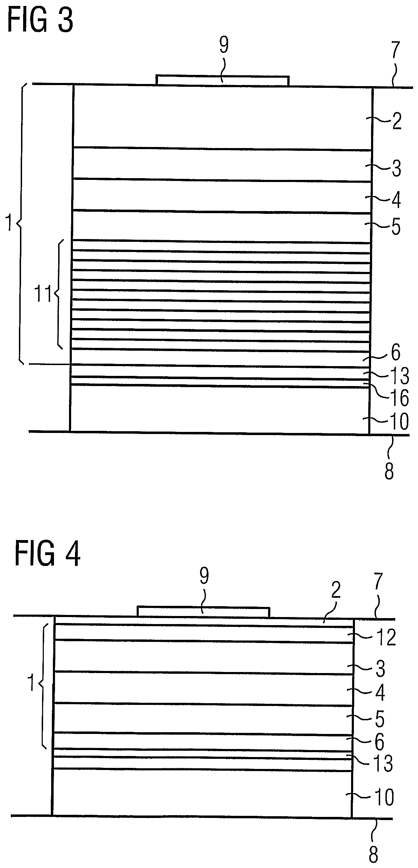

Im Unterschied zu dem Ausführungsbeispiel gemäß Figur 1 und zu der Abwandlung gemäß Figur 2 umfasst der Halbleiterchip des Ausführungsbeispiels gemäß der Figur 3 eine reflektierende Schicht, vorliegend einen DBR-Spiegel 11, der zwischen der p-Mantelschicht 5 und der p-Kontaktschicht 6 angeordnet ist. Der DBR-Spiegel 11 weist eine Folge von Schichten auf, vorliegend zwischen zehn und zwanzig, die alternierend einen hohen und einen niedrigen Brechungsindex aufweisen. In dem vorliegenden Ausführungsbeispiel kann der DBR-Spiegel zur Reflektion der Strahlung aus dem gelben bis roten Spektralbereich des sichtbaren Lichtes beispielsweise auf AlGaAs oder AlGaInP basieren, wobei jeweils durch Variation des Al- und des Ga-Gehaltes der Schichten die Brechungsindizes alternierend variiert werden.

Weiterhin weist der Hableiterchip gemäß der Figur 3 im Unterschied zu dem Halbleiterchip gemäß der Figur 1 eine Klebstoffschicht 16 auf, die zwischen der TCO-Kontaktschicht 13 und dem TCO-Stützsubstrat 10 angeordnet ist. Die Klebstoffschicht 16 enthält beispielsweise einen elektrisch leitenden, vorzugsweise für die Strahlung des Halbleiterchips durchlässigen Klebstoff.

Die Halbleiterschichtenfolge 1 kann alternativ auch mittels einem elektrisch isolierenden Klebstoff, wie beispielsweise BCB an dem TCO-Stützsubstrat 10 angebracht werden. Hierbei liegen die Rauhigkeiten der zu verbindenden Oberflächen zumindest im Bereich einiger nm. Die Klebstoffschicht 16 ist bei dieser Ausführungsform derart dünn ausgebildet, dass nur zwischen Erhebungen auf Grund der Rauhigkeit der zu verbindenden Oberflächen, Klebstoff enthalten ist, während die Oberflächen an den Erhebungen in direktem mechanischen Kontakt miteinander stehen, derart, dass sich ein elektrisch leitender Kontakt zwischen den Oberflächen ausbildet.

Wird ein elektrisch isolierender Klebstoff, beispielsweise BCB, verwendet, um die Halbleiterschichtenfolge 1 an dem TCO-Stützsubstrat 10 anzubringen, so kann dieser beispielsweise auf eine oder beide zu verbindenden Oberflächen in einer dünnen Schicht aufgeschleudert werden. Nachdem Aufbringen des Klebstoffes werden die beiden zu verbindenden Oberflächen miteinander in Kontakt gebracht. Durch Beaufschlagung mit Druck ist es nun möglich, überschüssigen Kleber seitlich herauszudrücken, so dass die Klebstoffschicht 16 so dünn ausgebildet wird, dass ein elektrischer Kontakt über Erhebungen der zu verbindenden Oberflächen entsteht, wie oben beschrieben.

Bei dem Ausführungsbeispiel gemäß der Figur 4 umfasst der Halbleiterchip im Unterschied zu dem Ausführungsbeispiel gemäß der Figur 1 eine n-Kontaktschicht 12 aus hoch n-dotiertem AlGaAs mit einer Dicke zwischen 50 und 200 nm, die auf der zur Vorderseite 7 des Halbleiterchips hin gewandten Seite der n-Mantelschicht 3 angeordnet ist. Der n-Kontaktschicht 12 ist, gesehen von der Halbleiterschichtenfolge 1, eine n-seitige Stromaufweitungsschicht 2 nachgeordnet, die ein TCO umfasst und eine Dicke zwischen 200 nm und 1 µm aufweist. Um den elektrischen Kontakt zwischen der n-Kontaktschicht 12 und der n-seitigen Stromaufweitungsschicht 2 aus TCO zu verbessern, bevorzugt derart, dass dieser eine Ohmsche Charakteristik aufweist, können zwischen diese beiden Schichten Kontaktstellen angeordnet sein, beispielsweise aus Au/Ge (in der Figur nicht dargestellt).

Wie bei dem Ausführungsbeispiel gemäß der Figur 1 ist bei dem Ausführungsbeispiel gemäß der Figur 4 eine TCO-Kontaktschicht 13, die ein TCO umfasst, zwischen der p-Kontaktschicht 6 und dem TCO-Stützsubstrat 10 angeordnet. Die TCO-Kontaktschicht 13 weist hierbei nicht notwendigerweise dasselbe Material auf wie das TCO-Stützsubstrat 10 und trägt zu einem verbesserten elektrischen Kontakt mit bevorzugt Ohmscher Charakteristik zwischen dem TCO-Stützsubstrat 10 und der Halbleiterschichtenfolge 1 bei. Das TCO-Stützsubstrat 10 kann beispielsweise mittels direktem Bonden oder Diffusionsbonden an der Halbleiterschichtenfolge befestigt sein. Alternativ kann das TCO-Stützsubstrat 10 auch mittels Kleben an der Halbleiterschichtenfolge befestigt sein.

## Patentansprüche

1. Optoelektronischer Halbleiterchip, der im Betrieb elektromagnetische Strahlung von seiner Vorderseite (7) emittiert, mit:
- einer Halbleiterschichtenfolge (1) mit einem aktiven Bereich (4), der geeignet ist, die elektromagnetische Strahlung zu erzeugen, und
- einem an der Halbleiterschichtenfolge angeordneten separat gefertigten TCO-Stützsubstrat (10), das ein Material aus der Gruppe der transparenten leitenden Oxide (TCO) aufweist und die Halbleiterschichtenfolge (1) mechanisch stützt, bei dem zwischen der Halbleiterschichtenfolge (1) und dem TCO-Stützsubstrat (10) eine TCO-Kontaktschicht (13) angeordnet ist, die einen elektrischen Kontakt zwischen der Halbleiterschichtenfolge (1) und dem TCO-Stützsubstrat (10) herstellt und ein Material aus der Gruppe der transparenten leitenden Oxide (TCOs) aufweist, und
die TCO-Kontaktschicht (13) eine Dicke aufweist, die ≥ 1 µm und ≤ 5 µm ist.

2. Optoelektronischer Halbleiterchip nach Anspruch 1, bei dem das TCO-Stützsubstrat einen Brechungsindex aufweist, der kleiner ist als der Brechungsindex der Halbleiterschichtenfolge.

3. Optoelektronischer Halbleiterchip nach einem der obigen Ansprüche, bei dem das TCO-Stützsubstrat (10) mittels direktem Bonden, Diffusionsbonden oder Kleben an der Halbleiterschichtenfolge angebracht ist.

4. Optoelektronischer Halbleiterchip nach einem der obigen Ansprüche, bei dem zwischen dem aktiven Bereich (4) der Halbleiterschichtenfolge (1) und dem TCO-Stützsubstrat (10) eine die Strahlung des Halbleiterchips reflektierende Schicht angeordnet ist.

5. Optoelektronischer Halbleiterchip nach Anspruch 4, bei dem die reflektierende Schicht ein DBR-Spiegel (11) (Distributed-Bragg-Reflektor-Spiegel) ist.

6. Optoelektronischer Halbleiterchip nach einem der obigen Ansprüche, bei dem eine Rückseite (8) des Halbleiterchips, die gegenüber dessen Vorderseite (7) angeordnet ist, eine Metallschicht (14) umfasst.

7. Optoelektronischer Halbleiterchip nach Anspruch 6, bei dem die Metallschicht (14) reflektierend für die Strahlung des Halbleiterchips ausgebildet ist.

8. Optoelektronischer Halbleiterchip nach einem der obigen Ansprüche, dessen Vorderseite (7) aufgeraut ist.

9. Optoelektronischer Halbleiterchip nach einem der obigen Ansprüche, bei dem auf der zu dessen Vorderseite (7) gewandten Seite der Halbleiterschichtenfolge (1) eine Stromaufweitungsschicht (2) angeordnet ist, die ein Material aus der Gruppe der TCOs aufweist.

## Claims

1. An optoelectronic semiconductor chip, which emits electromagnetic radiation from its front side (7) during operation, comprising:
- a semiconductor layer sequence (1) including an active region (4) which is suitable for generating the electromagnetic radiation, and
- a separately manufactured TCO supporting substrate arranged on the semiconductor layer sequence (10) which comprises a material from the group of transparent conductive oxides (TCO) and which mechanically supports the semiconductor layer sequence,
wherein a TCO contact layer (13) is arranged between the semiconductor layer sequence (1) and the TCO supporting substrate (10), the TCO contact layer (13) produces an electrical contact between the semiconductor layer sequence (1) and the TCO supporting substrate (10) and has a material from the group of transparent conductive oxides (tcos), and wherein the TCO contact layer (13) has a thickness which is ≥ 1 µm and ≤ 5 µm.

2. The optoelectronic semiconductor chip according to claim 1,
wherein the TCO supporting substrate has a refractive index which is smaller than the refractive index of the semiconductor layer sequence.

3. The optoelectronic semiconductor chip according to one of the above claims,
wherein the TCO supporting substrate (10) is attached to the semiconductor layer sequence by means of direct bonding, diffusion bonding or adhesive bonding.

4. The optoelectronic semiconductor chip according to one of the above claims,
wherein a layer reflecting the radiation of the semiconductor chip is arranged between the active region (4) of the semiconductor layer sequence (1) and the TCO supporting substrate (10).

5. The optoelectronic semiconductor chip according to claim 4,
wherein the reflective layer is a DBR mirror (11) (distributed Bragg reflector mirror).

6. The optoelectronic semiconductor chip according to one of the above claims,
wherein a rear side (8) of the semiconductor chip, which is arranged opposite the front side thereof, comprises a metal layer (14).

7. The optoelectronic semiconductor chip according to claim 6,
wherein the metal layer (14) is designed to be reflective for the radiation of the semiconductor chip.

8. The optoelectronic semiconductor chip according to one of the above claims,
the front side of which is roughened.

9. The optoelectronic semiconductor chip according to one of the above claims,
wherein on the side facing the front side of the optoelectronic semiconductor chip (7), a current spreading layer (2), which has a material from the group of TCOs, is arranged on the facing side of the semiconductor layer sequence (1).

## Revendications

1. Puce à semi-conducteur optoélectronique, laquelle, en fonctionnement, émet un rayonnement électromagnétique depuis son côté avant (7), comprenant :
- une succession de couches semi-conductrices (1) comprenant une zone active (4) qui est apte à générer le rayonnement électromagnétique, et
- un substrat de support TCO (10) fabriqué séparément, disposé sur la succession de couches semi-conductrices, lequel présente un matériau du groupe des oxydes transparents conducteurs (TCO) et soutient mécaniquement la succession de couches semi-conductrices (1),
dans laquelle
entre la succession de couches semi-conductrices (1) et le substrat de support TCO (10) est disposée une couche de contact TCO (13) qui établit un contact électrique entre la succession de couches semi-conductrices (1) et le substrat de support TCO (10) et présente un matériau du groupe des oxydes transparents conducteurs (TCO), et dans laquelle la couche de contact TCO (13) présente une épaisseur ≥ 1 µm et ≤ 5 µm.

2. Puce à semi-conducteur optoélectronique selon la revendication 1, dans laquelle le substrat de support TCO présente un indice de réfraction qui est inférieur à l'indice de réfraction de la succession de couches semi-conductrices.

3. Puce à semi-conducteur optoélectronique selon l'une quelconque des revendications ci-dessus, dans laquelle le substrat de support TCO (10) est appliqué sur la succession de couches semi-conductrices par liaison directe, par liaison par diffusion ou par collage.

4. Puce à semi-conducteur optoélectronique selon l'une quelconque des revendications ci-dessus, dans laquelle une couche réfléchissant le rayonnement de la puce à semi-conducteur est disposée entre la zone active (4) de la succession de couches semi-conductrices (1) et le substrat de support TCO (10).

5. Puce à semi-conducteur optoélectronique selon la revendication 4, dans laquelle la couche réfléchissante est un miroir DBR (11) (Distributed Bragg Reflector Mirror) .

6. Puce à semi-conducteur optoélectronique selon l'une quelconque des revendications ci-dessus, dans laquelle un côté arrière (8) de la puce à semi-conducteur, qui est disposé à l'opposé du côté avant (7) de celle-ci, comprend une couche métallique (14).

7. Puce à semi-conducteur optoélectronique selon la revendication 6, dans laquelle la couche métallique (14) est réalisée de manière réfléchissante pour le rayonnement de la puce à semi-conducteur.

8. Puce à semi-conducteur optoélectronique selon l'une quelconque des revendications ci-dessus, dont le côté avant (7) est rugueux.

9. Puce à semi-conducteur optoélectronique selon l'une quelconque des revendications ci-dessus, dans laquelle, sur le côté de la succession de couches semi-conductrices (1), tourné vers le côté avant (7) de la puce à semi-conducteur, est disposée une couche d'élargissement de courant (2), laquelle présente un matériau du groupe des TCO.
